# EUROPÄISCHE PATENTANMELDUNG

(11) **EP 4 576 953 A1**
(43) Veröffentlichungstag der Anmeldung: **25.06.2025**
(21) Anmeldenummer: 23219359.9
(22) Anmeldetag: 21.12.2023
(51) Int. Cl.: H05K 5/02, H05K 5/06, H05K 7/14, H05K 9/00

(54) **AUTOMATISIERUNGSKOMPONENTE**

(71) Anmelder: Siemens Aktiengesellschaft, 80333 München (DE)
(72) Erfinder: Görlich, Stefan, 92278 Illschwang (DE); Hubmann, Stefan, 92237 Sulzbach-Rosenberg (DE)
(74) Vertreter: Siemens Patent Attorneys

(57) **Zusammenfassung**

Die Erfindung betrifft eine Automatisierungskomponente (10) für die industrielle Automatisierung aufweisend ein Gehäuse (3) umfassend ein Oberteil (1) und ein Unterteil (2), wobei das Oberteil (1) und das Unterteil (2) derart ausgestaltet sind, dass zum Befestigen der Automatisierungskomponente (10) an einer Montagefläche (4) das Gehäuse (3) eine erste Befestigungsöffnung (21) und eine zweite Befestigungsöffnung (22) aufweist, wobei in das Oberteil (1) an den Stellen der Befestigungsöffnung (21,22) jeweils ein Massekontakt-Mittel (MKM) angeordnet ist, wobei das Massekontakt-Mittel (MKM) einen ersten Ring (R1) und einen zweiten Ring (R2) aufweist, welche über einen Kontaktschenkel (KS) miteinander verbunden sind, der erste Ring (R1) des jeweiligen Massekontakt-Mittels (MKM) umschließt dabei die jeweilige Befestigungsöffnung (21,22), der zweite Ring (2) ist derart im inneren des Oberteils (1) angeordnet, das ein Kontakt zu einer Leiterplatte hergestellt ist, der erste Ring (1) weist eine ringförmige Masse-Kontaktfläche (MKF) und eine ebenfalls ringförmige Tragfläche (TF) auf, wobei die ringförmige Masse-Kontaktfläche (MKF) im inneren der ringförmigen Tragfläche (TF) angeordnet ist, weiterhin steht die ringförmige Masse-Kontaktfläche (MKF) zylinderähnlich aus der ringförmigen Tragfläche (TF) heraus und schließt bündig mit einer Außenfläche des Oberteils (1) ab, wobei ein Übergang von der ringförmigen Masse-Kontaktfläche (MKF) zu der ringförmigen Tragfläche (TF) umlaufend scharfkantig ausgestaltet ist, welches zu einem spritzhautfreien, ebenen Übergang zwischen Masse-Kontaktfläche (MKF) und Gehäuseoberfläche des Oberteils (1) führt, die Tragfläche (TF) ist im Oberteil (1) eingebettet.

## Beschreibung

Die Erfindung betrifft eine Automatisierungskomponente für die industrielle Automatisierung aufweisend ein Gehäuse umfassend ein Oberteil und ein Unterteil, wobei das Oberteil und das Unterteil derart ausgestaltet sind, dass zum Befestigen der Automatisierungskomponente an einer Montagefläche das Gehäuse eine erste Befestigungsöffnung und eine zweite Befestigungsöffnung aufweist.

Beispielsweise bei einem Einsatz von Automatisierungsgeräten in medizinischen Bereichen oder in der Nahrungs- und Genussmittelindustrie bestehen an die dort eingesetzten Geräte besondere Anforderungen hinsichtlich der hygienischen Bedingungen. Diese Anforderungen beziehen sich im Wesentlichen auf die Reinigbarkeit der eingesetzten Geräte.

Nach dem Stand der Technik sind folgende Automatisierungs-Geräte bzw. Komponenten bekannt:
Balluff Network Interface IO-Link BNI IOL-252-000-Z013 gemäß Montageanleitung.
Digital Module AXL E IOL DI16 M12 6P gemäß https://www.phoenixcontact.com/us/products/2702660.
SIMATIC ET 200AL, DI 8x 24 V DC, 8XM8, Degree of protection IP67 gemäß Datenblatt vom 21.05.2020 bzw. gemäß Gerätehandbuch A5E32349561-AD von 08/2021.

All diese bekannten Automatisierungskomponenten haben den Nachteil, dass sie rund um ihre Befestigungsöffnung derart konstruiert sind, dass sich rund um die Befestigungsöffnung eine umlaufende Schmutzsammelkante bildet.

Es ist eine Aufgabe der Erfindung eine Automatisierungskomponente bereitzustellen, welche den Anforderungen der Lebensmittelindustrie bezüglich der Hygiene gerecht wird.

Die Aufgabe wird dadurch gelöst, dass in das Oberteil an den Stellen der Befestigungsöffnung jeweils ein Massekontakt-Mittel angeordnet ist, wobei das Massekontakt-Mittel einen ersten Ring und einen zweiten Ring aufweist, welche über einen Kontaktschenkel miteinander verbunden sind, der erste Ring des jeweiligen Massekontakt-Mittels umschließt dabei die jeweilige Befestigungsöffnung, der zweite Ring ist derart im Inneren des Oberteils angeordnet, dass ein Kontakt zu einer Leiterplatte hergestellt ist, der erste Ring weist eine ringförmige Masse-Kontaktfläche und eine ebenfalls ringförmige Tragfläche auf, wobei die ringförmige Masse-Kontaktfläche im Inneren der ringförmigen Tragfläche angeordnet ist, weiterhin steht die ringförmige Masse-Kontaktfläche zylinderähnlich aus der ringförmigen Tragfläche heraus und schließt bündig mit einer Außenfläche des Oberteils ab, wobei ein Übergang von der ringförmige Masse-Kontaktfläche zu der ringförmigen Tragfläche umlaufend scharfkantig ausgestaltet ist, welches zu einem spritzhautfreien, ebenen Übergang zwischen Masse-Kontaktfläche und Gehäuseoberfläche des Oberteils führt, die Tragfläche ist im Oberteil eingebettet.

Um bei Baugruppen oder Geräten die Anforderungen der Lebensmittelindustrie zu erfüllen, sind die Bereiche, welche sich in der Nähe des zu verarbeiteten Lebensmittels befinden, so auszuführen, dass keine Fremdkörper vom Gerät in das Lebensmittel gelangen können. Wenn Metallteile mit Biegungen in ein Kunststoffgehäuse eingespritzt bzw. umspritzt werden, kann an den Biegungen evtl. eine Spritzhaut entstehen, die sich ablösen und in das Lebensmittel gelangen kann. Diese gebogenen Metallteile sind meist die Verbindung von der Befestigungsschraube des Gerätes zur innenliegenden Elektronik. Entweder wurde komplett auf eingespritzte Metallteile verzichtet oder die Metalleinlegeteile waren nicht mit der Oberfläche des Kunststoffgehäuses bündig. Wenn die Oberflächen nicht bündig sind, sind die Bauteile nicht hygienegerecht.

Bei der erfindungsgemäßen Baugruppe wird das Massekontakt-Mittel als Metalleinlegeteil im Bereich der Anschraubbohrung, also der Befestigungsöffnung, des Geräts so umgeformt, dass eine umlaufend nahezu scharfkantige Geometrie entsteht und im Bereich des Übergangs zum Gehäuse keine sich lösende Spritzhaut entsteht. Das Umformen kann ein Stanzen, Prägen oder Ähnliches sein.

Damit die Automatisierungskomponente sicher an einer Montagefläche befestigt werden kann weist das Unterteil einen ersten Fuß und einen zweiten Fuß auf, wobei die Füße einstückig mit dem Unterteil ausgebildet sind und die erste Befestigungsöffnung durch den ersten Fuß und die zweite Befestigungsöffnung durch den zweiten Fuß verläuft, die Füße weisen zum Befestigen auf der Montagefläche einen Befestigungsbereich auf, dazu ist eine Kontaktfläche innerhalb des Befestigungsbereiches angeordnet, wobei ein Loch der Befestigungsöffnung wiederum innerhalb der Kontaktfläche angeordnet ist, die Kontaktfläche ist derart ausgestaltet, dass sie aus dem Befestigungsbereich herausragt und dadurch eine die Kontaktfläche ringförmig umschließende Aussparung gebildet ist, die Aussparung ist damit zwischen der herausragenden Kontaktfläche und einem äußeren Randbereich des Befestigungsbereiches angeordnet, der äußere Randbereich ist als ein umlaufender Kragen um die Aussparung ausgestaltet, wobei der Kragen tiefer angeordnet ist als die herausragende Kontaktfläche und eine zur Montagefläche gerichtete Kragenfläche aufweist, ein ringförmiges Dichtelement aufweisend eine Dichtlippe, eine erste Auflagefläche und eine zweite Auflagefläche, ist derart ausgestaltet, dass die Dichtlippe in der Aussparung, die erste Auflagefläche auf der Kragenfläche und die zweite Auflagefläche zur Montagefläche angeordnet ist, wobei das Dichtelement die herausragende Kontaktfläche ringförmig umschließt, wobei durch ein Befestigungsmittel, welches durch die Befestigungsöffnung geführt ist, die Automatisierungskomponente fest an die Montagefläche gepresst wird und ein Massekontakt von der Montagefläche über das Massekontakt-Mittel hergestellt ist.

Damit Flüssigkeiten von der Automatisierungskomponente gut und rasch abfließen können ist das Gehäuse und damit das Oberteil und das Unterteil derart ausgestaltet, dass sich in einer Vorzugseinbaulage, bei welcher die Befestigungsöffnungen senkrecht übereinanderstehen, das Gehäuse ausgehend von der ersten Befestigungsöffnung sich in Richtung der zweiten Befestigungsöffnung verjüngt.

Vorteilhafter ist das Gehäuse derart ausgestaltet, dass Flächen derart geformt sind, dass eine Ablagerung von Verunreinigungen vermieden oder minimiert wird. Also keinen scharfen Kanten oder Vertiefungen.

Durch die Füße ist eine ausreichend gute Zugänglichkeit aller Oberflächen der Automatisierungsbaugruppe für die Reinigung, auch mit Niedrigdruck-Wasser und mittels Putzlappen mit der Hand möglich.

Dementsprechend ist das Gehäuse und damit das Oberteil und das Unterteil als eine sich längsersteckende Umhausung zwischen dem ersten Fuß und dem zweiten Fuß ausgestaltet ist, wobei die Füße zumindest eine Länge aufweisen, dass die Oberfläche des Unterteils so zur Montagefläche beabstandet ist, dass eine menschliche Hand mit einem Putzmittel hindurch gleiten kann.

Eine besondere Ausgestaltung sieht vor, dass das Befestigungselement ein Schraubbolzen ist, welcher unter seinem Kopf einen umlaufenden Rand aufweist, welche auf die Masse-Kontaktfläche drückt bzw. auf dieser zum Teil aufliegt. Ein Schraubenkopf-Dichtelement schließt bündig mit der Masse-Kontaktfläche ab, wobei das Schraubenkopf-Dichtelement in seiner Dicke etwas größer als der umlaufende Rand unter dem Kopf ist, so dass im montierten Zustand zwischen dem Schraubenkopf und der Masse-Kontaktfläche das Schraubenkopf-Dichtelement derart komprimiert angeordnet ist, dass sich dazwischen ein spaltfreier Übergang ausbildet. Die Dicke ist etwas größer als der Abstand zwischen den zwei Flächen.

Die Zeichnung zeigt ein Ausführungsbeispiel der Erfindung, dabei zeigt die
- FIG 1: eine Automatisierungskomponente in Ausgestaltung einer I/O Baugruppe,
- FIG 2: eine Detaildarstellung der Automatisierungskomponente mit einem Fokus auf die erste Befestigungsöffnung in der eine Schraube angeordnet ist,
- FIG 3: eine Schnittdarstellung durch die erste Befestigungsöffnung, und
- FIG 4: ein Massekontakt-Mittel zum Einspritzen in ein Gehäuse,
- FIG 5: die Automatisierungskomponente in einer dreidimensionalen Ansicht auf eine Hinterseite und
- FIG 6: eine Detaildarstellung eines Fußes der Automatisierungskomponente.

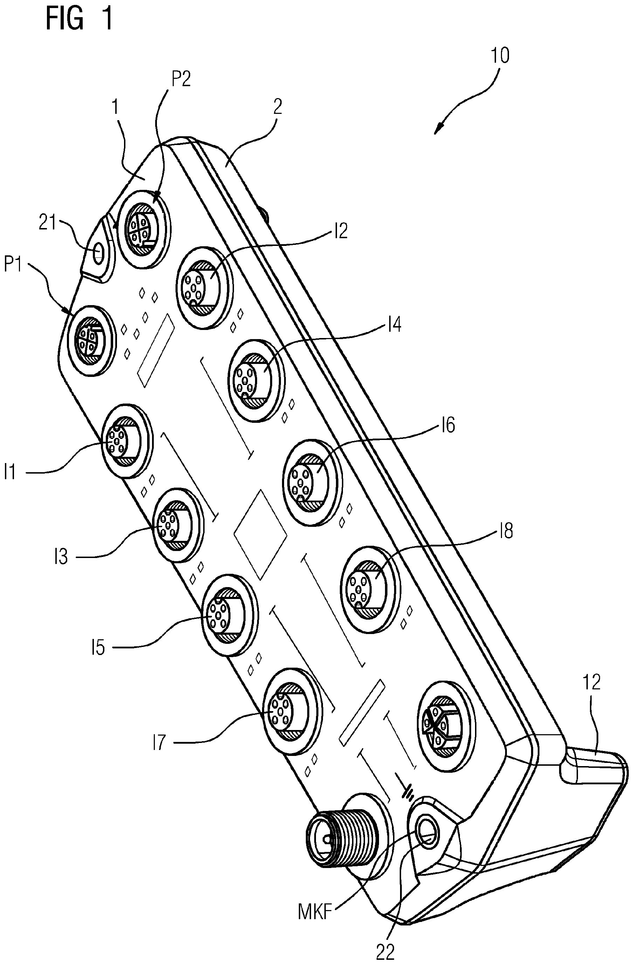

Gemäß FIG 1 ist eine Automatisierungskomponente 10 für die industrielle Prozessautomatisierung dargestellt. Die Automatisierungskomponente 10 ist ausgestaltet, als ein I/O Peripheriemodul. Die Automatisierungskomponente 10 weist ein Gehäuse 3 umfassend ein Oberteil 1 und ein Unterteil 2 auf, wobei das Oberteil 1 und das Unterteil 2 derart ausgestaltet sind, dass zum Befestigen der Automatisierungskomponente 10 an einer Montagefläche 4 das Gehäuses 3 eine erste Befestigungsöffnung 21 und eine zweite Befestigungsöffnung 22 aufweist.

Die Automatisierungskomponente 10 weist für eine Kommunikation zu Sensoren oder Aktoren mit dem I/O Protokoll einen ersten bis achten I/O Anschluss I1, ... , I8 auf. Damit die Automatisierungskomponente 10 Signale von einer übergeordneten Steuerung empfangen kann, weist sie einen ersten Profinet-Anschluss P1 auf. Ein weiterer zweiter Profinet-Anschluss P2 dient dazu, weitere Automatisierungskomponenten mit dem Profinet zu verbinden.

Das Unterteil 2 weist einen ersten Fuß 11 und einen zweiten Fuß 12 auf, wobei die Füße 11,12 einstückig mit dem Unterteil 2 ausgebildet sind.

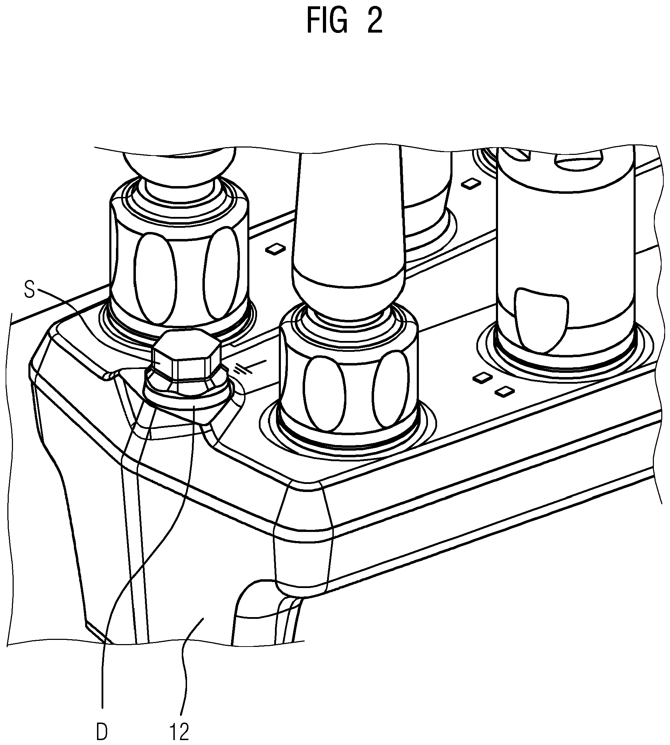

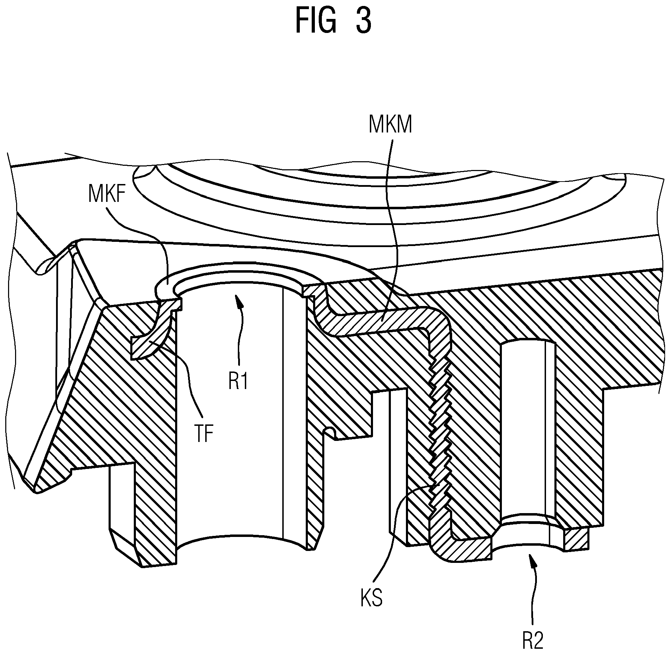

Gemäß FIG 2 ist die Automatisierungskomponente 10 aus FIG 1 in einer Detaildarstellung mit Bezug auf die erste Befestigungsöffnung 21 dargestellt. In der Befestigungsöffnung 21 ist eine Schraube S mit einem Dichtelement D angeordnet. Das Dichtelement D liegt bündig auf der Masse-Kontaktfläche MKF (siehe FIG 1 und FIG 3) auf. Die Schraube S stellt nun das Befestigungselement bzw. einen Schraubbolzen dar. Der Schraubbolzen hat unter seinen Kopf einen umlaufenden Rand, welcher auf die Masse-Kontaktfläche MKF drückt bzw. auf dieser zum Teil aufliegt. Das Schraubenkopf-Dichtelement schließt bündig mit der Masse-Kontaktfläche MKF ab, wobei das Schraubenkopf-Dichtelement in seiner Dicke etwas größer als der umlaufende Rand unter dem Kopf ist, so dass im montierten Zustand zwischen dem Schraubenkopf und der Masse-Kontaktfläche MKF das Schraubenkopf-Dichtelement derart komprimiert angeordnet ist, dass sich dazwischen ein spaltfreier Übergang ausbildet.

Mit der FIG 3 wird in einer Schnittdarstellung gezeigt, wie das Masse-Kontaktmittel MKM in dem Oberteil 1 des Gehäuses 3 angeordnet ist bzw. bei einem Fertigungsvorgang mit Kunststoff umspritzt wurde. Das Masse-Kontaktmittel MKM weist einen ersten Ring R1 und einen zweiten Ring R2 auf. Der erste Ring R1 und der zweite Ring R2 sind über einen Kontaktschenkel KS miteinander verbunden. Der Kontaktschenkel KS ist stellenweise gezackt ausgebildet, damit er in dem umspritzten Kunststoff eine höhere Dichtigkeit erreicht. Der erste Ring R1 umschließt die erste Befestigungsöffnung 21. Der zweite Ring R2 ist derart im Inneren des Oberteils 1 angeordnet, dass ein Kontakt zu einer Leiterplatte hergestellt ist. Der erste Ring R1 weist eine ringförmige Masse-Kontaktfläche MKF auf und weiterhin weist er eine ebenfalls ringförmige Tragfläche TF auf. Die ringförmige Masse-Kontaktfläche MKF ist im Inneren der ringförmigen Tragfläche TF angeordnet, wobei die ringförmige Masse-Kontaktfläche MKF zylinderähnlich aus der ringförmigen Tragfläche TF heraussteht und bündig mit der Außenfläche des Oberteils 1 abschließt. Ein Übergang von der ringförmigen Mase-Kontaktfläche MKF zu der ringförmigen Tragfläche TF ist scharfkantig ausgestaltet. Dieses scharfkantige Ausgestalten sorgt bei einen Spritzgussverfahren für einen spaltfreien ebenen Übergang zwischen der Masse-Kontaktfläche MKF und der Gehäusefläche des Oberteils 1. Für eine hohe Stabilität, insbesondere im Bereich der ersten Befestigungsöffnung ist die Tragfläche TF in das Oberteil 1 wesentlich tiefer eingebettet und mit viel Kunststoff umgeben, um so einen konstruktiven Halt zu erreichen.

Als wesentlich wird angesehen, dass im Bereich der Anschraubbohrung, also im Bereich der ersten Befestigungsöffnung 21 das Masse-Kontaktmittel MKM als Blechstanzteil derart geprägt bzw. gestanzt ist, dass eine umlaufend nahezu scharfkantige Geometrie entsteht und im Bereich des Übergangs zum Gehäuse keine, sich lösende Spritzhaut entsteht.

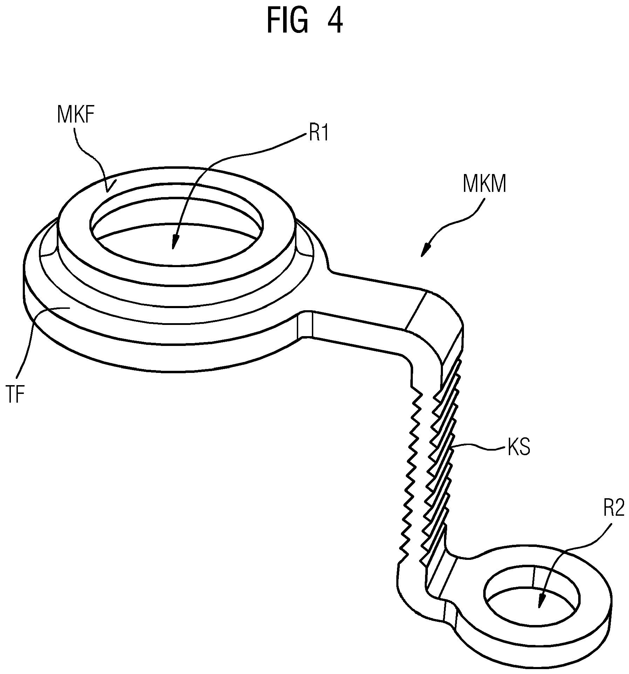

Mit der FIG 4 ist das Masse-Kontaktteil MKM als bereits gebogenes Blechstanzteil dargestellt. Der erste Ring R1 weist die ringförmige Masse-Kontaktfläche MKF auf, welche erhaben im Inneren der Tragfläche TF heraussteht. Der Übergang der Masse-Kontaktfläche MKF zur Tragfläche TF ist scharfkantig ausgestaltet. An dem ersten Ring R1 schließt sich ein erster Schenkel S1 an und daran ist ein Kontaktschenkel KS, welcher rechtwinklig nach unten abgebogen ist, mit einer gezackten Ausgestaltung angeordnet. Wiederum am anderen Ende des Kontaktschenkels KS ist rechtwinklig der zweite Ring R2 angeordnet. Der Kontaktschenkel KS ist geriffelt gezackt ausgestaltet damit das Ganze Masse-Kontaktmittel MKM im eingespritzten Zustand in dem Gehäuse eine bessere Dichtigkeit aufweist, denn bei beispielweise extremen Temperaturschwankungen zum Beispiel -30 Grad nach +40 Grad, könnte es sein, das doch einmal Wasser über Masse-Kontaktteil MKM eindringt. Durch die gezackte Ausgestaltung des Kontaktschenkels hat aber nun das eingedrungene Wasser einen längeren Weg, bis es in der Baugruppe ankommen würde.

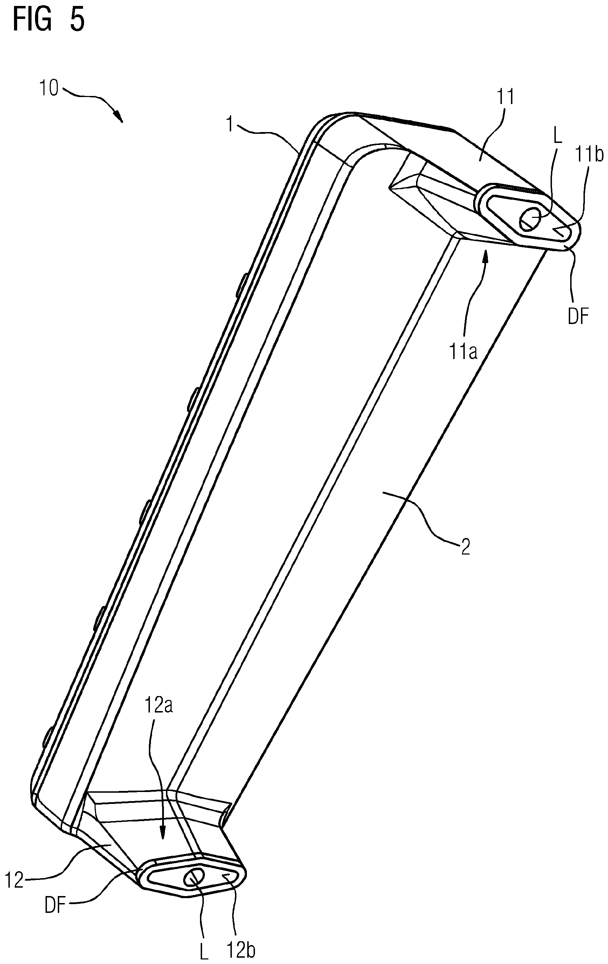

Mit der FIG 5 wird die einstückige Ausbildung des ersten Fu-ßes 11 und des zweiten Fußes 12 verdeutlicht. Die erste Befestigungsöffnung 21 verläuft durch den ersten Fuß 11 und die zweite Befestigungsöffnung 22 verläuft durch den zweiten Fuß 12. Der erste Fuß 11 und der zweite Fuß 12 weisen zum Befestigen auf der Montagefläche 4 ein Befestigungsbereich 11a bzw. 12a auf. Für eine Befestigung auf der Montagefläche 4 ist eine Kontaktfläche 11b bzw. 12b innerhalb des Befestigungsbereiches 11a,12a angeordnet. Ein Loch L der ersten Befestigungsöffnung 21 ist wiederum innerhalb der ersten Kontaktfläche 11b angeordnet. Auch ist ein Loch L in der zweiten Befestigungsöffnung 22 wiederum in der zweiten Kontaktfläche 12b angeordnet.

Die Kontaktflächen 11b,12b sind derart ausgestaltet, dass sie aus dem jeweiligen Befestigungsbereich 11a,12a herausragen und dadurch eine die Kontaktfläche 11b,12b ringförmig umschließende Aussparung A gebildet ist.

In dem ersten Fuß 11 und dem zweiten Fuß 12 ist jeweils ein Dichtelement DF eingesetzt. Das Dichtelement DF schließt bündig mit der Außenfläche des ersten Fußes 11 ab, wobei das Dichtelement DF an dieser Stelle in seiner Dicke etwas größer ist als die herausragende Kontaktfläche, um so in einem montierten Zustand zwischen einer Kragenfläche KF und der Montagefläche das Dichtelement DF komprimiert anzuordnen, so dass sich dazwischen ein spaltfreier Übergang ausbildet.

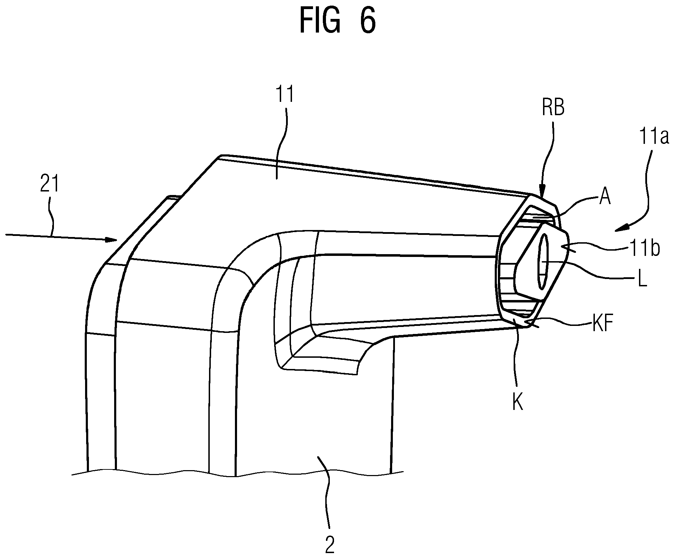

Die FIG 6 zeigt in einer Ausschnittdarstellung ein Detail des ersten Fußes 11. Der erste Fuß 11 weist zum Befestigen auf der Montagefläche 4 einen Befestigungsbereich 11a auf, dazu ist eine Kontaktfläche 11b innerhalb des Befestigungsbereiches 11a angeordnet, wobei ein Loch L der Befestigungsöffnung 21 wiederum innerhalb der Kontaktfläche 11b angeordnet ist.

Die Kontaktfläche 11b ist derart ausgestaltet, dass sie aus dem Befestigungsbereich 11a herausragt und dadurch eine die Kontaktfläche 11b ringförmig umschließende Aussparung A gebildet ist. Die Aussparung A ist damit zwischen der herausragenden Kontaktfläche 11b und einem äußeren Randbereich RB des Befestigungsbereiches 11a angeordnet. Der äußere Randbereich RB ist als ein umlaufender Kragen K um die Aussparung A ausgestaltet, wobei der Kragen K tiefer angeordnet ist, als die herausragende Kontaktfläche 11b und eine zur Montagefläche 4 gerichtete Kragenfläche KF aufweist.

## Patentansprüche

1. Automatisierungskomponente (10) für die industrielle Automatisierung aufweisend ein Gehäuse (3) umfassend ein Oberteil (1) und ein Unterteil (2), wobei das Oberteil (1) und das Unterteil (2) derart ausgestaltet sind, dass zum Befestigen der Automatisierungskomponente (10) an einer Montagefläche (4) das Gehäuse (3) eine erste Befestigungsöffnung (21) und eine zweite Befestigungsöffnung (22) aufweist,
**dadurch gekennzeichnet, dass** in das Oberteil (1) an den Stellen der Befestigungsöffnung (21,22) jeweils ein Massekontakt-Mittel (MKM) angeordnet ist, wobei das Massekontakt-Mittel (MKM) einen ersten Ring (R1) und einen zweiten Ring (R2) aufweist, welche über einen Kontaktschenkel (KS) miteinander verbunden sind, der erste Ring (R1) des jeweiligen Massekontakt-Mittels (MKM) umschließt dabei die jeweilige Befestigungsöffnung (21,22), der zweite Ring (2) ist derart im inneren des Oberteils (1) angeordnet, das ein Kontakt zu einer Leiterplatte hergestellt ist, der erste Ring (1) weist eine ringförmige Masse-Kontaktfläche (MKF) und eine ebenfalls ringförmige Tragfläche (TF) auf, wobei die ringförmige Masse-Kontaktfläche (MKF) im inneren der ringförmigen Tragfläche (TF) angeordnet ist, weiterhin steht die ringförmige Masse-Kontaktfläche (MKF) zylinderähnlich aus der ringförmigen Tragfläche (TF) heraus und schließt bündig mit einer Außenfläche des Oberteils (1) ab, wobei ein Übergang von der ringförmigen Masse-Kontaktfläche (MKF) zu der ringförmigen Tragfläche (TF) umlaufend scharfkantig ausgestaltet ist, welches zu einem spritzhautfreiem, ebenen Übergang zwischen Masse-Kontaktfläche (MKF) und Gehäuseoberfläche des Oberteils (1) führt, die Tragfläche (TF) ist im Oberteil (1) eingebettet.

2. Automatisierungskomponente (10) nach Anspruch 1, wobei das Unterteil (2) einen ersten Fuß (11) und einen zweiten Fuß (12) aufweist, wobei die Füße (11,12) einstückig mit dem Unterteil (2) ausgebildet sind und die erste Befestigungsöffnung (21) durch den ersten Fuß (11) und die zweite Befestigungsöffnung (22) durch den zweiten Fuß (12) verläuft, die Füße (11,12) weisen zum Befestigen auf der Montagefläche (4) einen Befestigungsbereich (11a,12a) auf, dazu ist eine Kontaktfläche (11b,12b) innerhalb des Befestigungsbereiches (11a,12a) angeordnet, wobei ein Loch (L) der Befestigungsöffnung (21) wiederum innerhalb der Kontaktfläche (11b,12b) angeordnet ist, die Kontaktfläche (11b,12b) ist derart ausgestaltet, dass sie aus dem Befestigungsbereich (11a,12a) herausragt und dadurch eine die Kontaktfläche (11b,12b) ringförmig umschließende Aussparung (A) gebildet ist, die Aussparung (A) ist damit zwischen der herausragenden Kontaktfläche (11b,12b) und einem äußeren Randbereich (RB) des Befestigungsbereiches (11a,12a) angeordnet, der äußere Randbereich (RB) ist als ein umlaufender Kragen (K) um die Aussparung (A) ausgestaltet, wobei der Kragen (K) tiefer angeordnet ist als die herausragende Kontaktfläche (11b) und eine zur Montagefläche (4) gerichtete Kragenfläche (KF) aufweist, ein ringförmiges Dichtelement (D) aufweisend eine Dichtlippe (DL), eine erste Auflagefläche (A1) und eine zweite Auflagefläche (A2), derart ausgestaltet, dass die Dichtlippe (DL) in der Aussparung (A), die erste Auflagefläche (A1) auf der Kragenfläche (KF) und die zweite Auflagefläche (A2) zur Montagefläche (4) angeordnet ist, wobei das Dichtelement (D) die herausragende Kontaktfläche (11b) ringförmig umschließt, wobei durch ein Befestigungsmittel (S), welches durch die Befestigungsöffnung (21,22) geführt ist, die Automatisierungskomponente (10) fest an die Montagefläche (4) gepresst wird und einen Massekontakt zur von der Montagefläche (4) über das Massekontakt-Mittels (MKM) hergestellt ist.

3. Automatisierungskomponente (10), nach Anspruch 1 oder 2, wobei das Gehäuse (3) und damit das Oberteil (1) und das Unterteil (2) derart ausgestaltet sind, dass sich in einer Vorzugseinbaulage (VE), bei welcher die Befestigungsöffnungen (21,22) senkrecht übereinanderstehen, das Gehäuse (3) ausgehend von der ersten Befestigungsöffnung (21) sich in Richtung der zweiten Befestigungsöffnung (22) verjüngt.

4. Automatisierungskomponente (10), nach einem der Ansprüche 1 bis 3, wobei das Gehäuse (3) derart ausgestaltet ist, dass Flächen derart geformt sind, dass eine Ablagerung von Verunreinigungen vermieden oder minimiert wird.
